# EUROPEAN PATENT APPLICATION

(11) **EP 4 783 408 A1**
(43) Date of publication of application: **29.07.2026**
(21) Application number: 25842438.1
(22) Date of filing: 18.06.2025
(51) Int. Cl.: H02J 7/00, G01R 19/165, H01M 10/42, B60L 3/00

(54) **CIRCUIT AND METHOD FOR ENHANCING CHARGE/DISCHARGE NOISE CHARACTERISTICS AND VEHICLE SYSTEM INCLUDING SAME**

(30) Priority: 05.12.2024 KR 20240179078
(71) Applicant: LG ENERGY SOLUTION, LTD., Seoul 07335 (KR)
(72) Inventor: KIM, Youngbeom, Yuseong-gu, Daejeon 34122 (KR); JO, Yongmin, Yuseong-gu, Daejeon 34122 (KR)
(74) Representative: BCKIP Part mbB
(86) International application number: PCT/KR2025/008392
(87) International publication number: WO 2026/121434

(57) **Abstract**

A charge/discharge noise characteristic enhancement circuit may include a register configured to detect an abnormal signal and output a first micro control unit (MCU) reset signal and a register signal, a first delay circuit configured to delay the first MCU reset signal output from the register and output a second MCU reset signal, an AND gate configured to receive the second MCU reset signal and the register signal and output a third MCU reset signal, a second delay circuit configured to delay the third MCU reset signal output from the AND gate and output a fourth MCU reset signal, and an MCU configured to perform a reset operation based on the first MCU reset signal or the fourth MCU reset signal.

## Description

### [TECHNICAL FIELD]

The present disclosure relates to a charge/discharge noise characteristic enhancement circuit and method, and a vehicle system including the same, and more particularly, to a circuit and method for enhancing noise generated during charging/discharging of a battery and a vehicle system including the same.

### [BACKGROUND ART]

A battery management system (BMS) refers to a system for monitoring, managing, and/or controlling the state of a battery. For example, the battery management system may include a plurality of micro control units (MCUs). When the battery management system detects an abnormal signal, the battery management system transmits a reset command to a relevant MCU to cut off the power of the system. However, an abnormal signal may be incorrectly detected due to noise generated during charging/discharging of a battery, which causes a problem that an MCU is reset unintentionally.

### [DETAILED DESCRIPTION OF INVENTION]

### [TECHNICAL PROBLEMS]

The present disclosure provides a charge/discharge noise characteristic enhancement circuit and method, a computer program stored in a computer-readable medium, a computer-readable medium storing the computer program, and a system (device) for solving the above problem.

### [TECHNICAL SOLUTION]

The present disclosure can be implemented in various ways, including a circuit, method, and system (device) for enhancing charge/discharge noise characteristics, a computer program stored in a computer-readable medium, or a computer-readable medium having a computer program stored therein.

According to an embodiment of the present disclosure, a charge/discharge noise characteristic enhancement circuit may include a register configured to detect an abnormal signal and output a first micro control unit (MCU) reset signal and a register signal, a first delay circuit configured to delay the first MCU reset signal output from the register and output a second MCU reset signal, an AND gate configured to receive the second MCU reset signal and the register signal and output a third MCU reset signal, a second delay circuit configured to delay the third MCU reset signal output from the AND gate and output a fourth MCU reset signal, and a MCU configured to perform a reset operation based on the first MCU reset signal or the fourth MCU reset signal.

According to an embodiment of the present disclosure, the charge/discharge noise characteristic enhancement circuit may further include a comparator configured to determine a normal operation or a charge/discharge operation of a battery based on a current value received from a current sensor.

According to an embodiment of the present disclosure, the comparator may be configured to determine the normal operation or the charge/discharge operation of the battery based on whether the current value received from the current sensor is higher than a threshold value.

According to an embodiment of the present disclosure, the charge/discharge noise characteristic enhancement circuit may further include a first switch connecting the register and the MCU. The first switch is controlled to be turned on by a first comparison signal output from the comparator based on the current value received from the current sensor being determined to be lower than a threshold value.

According to an embodiment of the present disclosure, the charge/discharge noise characteristic enhancement circuit may further include a second switch connecting the register and the first delay circuit. The second switch may be controlled to be turned on by a second comparison signal output from the comparator based on the current value received from the current sensor being determined to be higher than a threshold value.

According to an embodiment of the present disclosure, the charge/discharge noise characteristic enhancement circuit may further include a buffer configured to receive the register signal and transmit the register signal to the first delay circuit.

According to an embodiment of the present disclosure, the first delay circuit may be configured to output the second MCU reset signal based on the first MCU reset signal being maintained as a HIGH signal during a first delay time.

According to an embodiment of the present disclosure, the AND gate may be configured to output the third MCU reset signal based on both the second MCU reset signal and the register signal being HIGH signals.

According to an embodiment of the present disclosure, the second delay circuit may be configured to output the fourth MCU reset signal based on the third MCU reset signal being maintained as a HIGH signal during a second delay time.

According to an embodiment of the present disclosure, a vehicle system may include a battery pack, a charger/discharger configured to charge and discharge the battery pack, a current sensor connected between the battery pack and the charger/discharger and configured to provide current flowing in the battery pack to a battery management system (BMS), and the battery management system including a charge/discharge noise characteristic enhancement circuit configured to detect an abnormal signal and reset a micro control unit (MCU).

According to an embodiment of the present disclosure, the charge/discharge noise characteristic enhancement circuit may include a register configured to detect the abnormal signal and output a first MCU reset signal and a register signal, a first delay circuit configured to delay the first MCU reset signal output from the register and output a second MCU reset signal, an AND gate configured to receive the second MCU reset signal and the register signal and output a third MCU reset signal, a second delay circuit configured to delay the third MCU reset signal output from the AND gate and output a fourth MCU reset signal. Further, the MCU may be configured to perform a reset operation based on the first MCU reset signal or the fourth MCU reset signal.

According to an embodiment of the present disclosure, a battery charge/discharge noise enhancement method performed by at least one processor may include generating a first micro control unit (MCU) reset signal and a register signal using a register, generating a second MCU reset signal by delaying the first MCU reset signal using a first delay circuit, providing the second MCU reset signal and the register signal to an AND gate to generate a third MCU reset signal, generating a fourth MCU reset signal by delaying the third MCU reset signal using a second delay circuit, and performing a reset operation of an MCU based on the fourth MCU reset signal.

According to an embodiment of the present disclosure, the battery charge/discharge noise enhancement method may further include determining a normal operation or a charge/discharge operation of a battery based on a current value received from a current sensor using a comparator.

According to an embodiment of the present disclosure, the generating the second MCU reset signal by delaying the first MCU reset signal using the first delay circuit may include determining whether the first MCU reset signal is maintained as a HIGH signal during a first delay time, and generating the second MCU reset signal based on the first MCU reset signal being determined to be maintained as the HIGH signal during the first delay time.

According to an embodiment of the present disclosure, the generating the fourth MCU reset signal by delaying the third MCU reset signal using the second delay circuit may include determining whether the third MCU reset signal is maintained as a HIGH signal during a second delay time, and generating the fourth MCU reset signal based on the third MCU reset signal being determined to be maintained as the HIGH signal during the second delay time.

According to an embodiment of the present disclosure, the generating the fourth MCU reset signal by delaying the third MCU reset signal using the second delay circuit may further include determining whether an abnormal operation of the MCU is detected during the second delay time. The generating the fourth MCU reset signal may include generating the fourth MCU reset signal based on the third MCU reset signal being maintained as the HIGH signal during the second delay time and the abnormal operation of the MCU being detected based on the third MCU reset signal being determined to be maintained as the HIGH signal during the second delay time.

According to an embodiment of the present disclosure, the determining whether the abnormal operation of the MCU is detected during the second delay time may include determining whether a reset register signal output from a reset register is a HIGH signal, determining whether the register signal is a HIGH signal based on the reset register signal being the HIGH signal, determining whether a power cutoff command has been output based on the register signal being the HIGH signal, and determining that the abnormal operation of the MCU is detected based on the power cutoff command being determined to have been output.

### [EFFECT OF INVENTION]

In various embodiments of the present disclosure, a vehicle and/or a vehicle system can precisely distinguish between noise and actual abnormal signals generated during charging and discharging of a battery pack to perform MCU reset control.

In various embodiments of the present disclosure, a battery management system can enhance characteristics of noise generated during charging and discharging of a battery and/or a battery pack based on the charge/discharge noise characteristic enhancement circuit, and effectively prevent an MCU from being incorrectly reset due to charge/discharge noise based on the enhanced noise characteristics.

The effects of the present disclosure are not limited to the effects mentioned above, and other effects not mentioned can be clearly understood by a person having ordinary knowledge in the technical field to which the present disclosure belongs (referred to as "ordinary technician") from the description of the claims.

### [BRIEF DESCRIPTION OF THE DRAWING]

Embodiments of the present disclosure will be described with reference to the accompanying drawings, wherein like reference numerals represent like elements, but are not limited thereto.
FIG. 1 is a diagram illustrating an example of a vehicle including a charge/discharge noise characteristic enhancement circuit according to an embodiment of the present disclosure.
FIG. 2 is a diagram illustrating the operation of the charge/discharge noise characteristic enhancement circuit during a normal operation according to an embodiment of the present disclosure.
FIG. 3 is a diagram illustrating the operation of the charge/discharge noise characteristic enhancement circuit during an operation of charging/discharging a battery according to an embodiment of the present disclosure.
FIG. 4 is a flowchart illustrating an example of a charge/discharge noise characteristic enhancement method according to an embodiment of the present disclosure.
FIG. 5 is a flowchart illustrating an example of a method of detecting an abnormal operation of an MCU according to an embodiment of the present disclosure.
FIG. 6 illustrates a computing device for performing the above-described method and/or embodiment.

### [BEST MODE FOR CARRYING OUT THE INVENTION]

Hereinafter, specific details for implementing the present disclosure will be described in detail with reference to the attached drawings. However, in the following description, if there is a concern that the gist of the present disclosure may be unnecessarily obscured, specific descriptions of widely known functions or configurations will be omitted.

In the attached drawings, identical or corresponding components are given the same reference numerals. In addition, in the description of the embodiments below, redundant descriptions of identical or corresponding components may be omitted. However, even if the description of a component is omitted, it is not intended that such a component is not included in any embodiment.

The advantages and features of the embodiments disclosed in this specification, and methods for achieving the same will become clear with reference to the embodiments described below together with the attached drawings. However, the present disclosure is not limited to the embodiments disclosed below, but may be implemented in various different forms, and these embodiments are only provided to fully inform a person skilled in the art related to the present disclosure of the scope of the disclosure.

The terms used in this specification will be briefly explained, and the disclosed embodiments will be described in detail. The terms used in this specification are selected from the most widely used general terms possible while considering the functions of the present disclosure, but they may vary depending on the intention of engineers working in the relevant field, precedents, or the emergence of new technologies. In addition, in certain cases, there are terms arbitrarily selected by the applicant, and in this case, the meanings thereof will be described in detail in the description of the disclosure. Therefore, the terms used in the present disclosure should be defined based on the meanings of the terms and the overall contents of the present disclosure, rather than simply the names of the terms.

In this specification, singular expressions include plural expressions unless the context clearly specifies that they are singular. In addition, plural expressions include singular expressions unless the context clearly specifies that they are plural. In the specification, when a part is said to include a certain component, this does not mean that other components are excluded, but rather that other components may be included unless otherwise specifically stated.

In the present disclosure, the terms "comprise", "comprising", and the like may indicate the presence of features, steps, operations, elements, and/or components, but such terms do not exclude addition of one or more other functions, steps, operations, elements, components, and/or combinations thereof.

In the present disclosure, when a particular component is referred to as being "coupled", "combined", "connected", "associated", or "reacting" with any other component, the particular component may be directly coupled, combined, connected, and/or associated with, or reacting with the other component, but is not limited thereto. For example, one or more intermediate components may be present between the particular component and another component. Further, in the present disclosure, "and/or" may include each of one or more listed items or at least a combination of part of one or more of listed items.

In the present disclosure, the terms "first", "second", etc. are used to distinguish a particular component from other components, and the components described above are not limited by these terms. For example, the "first" component may be used to refer to an element of the same or similar form as the "second" component.

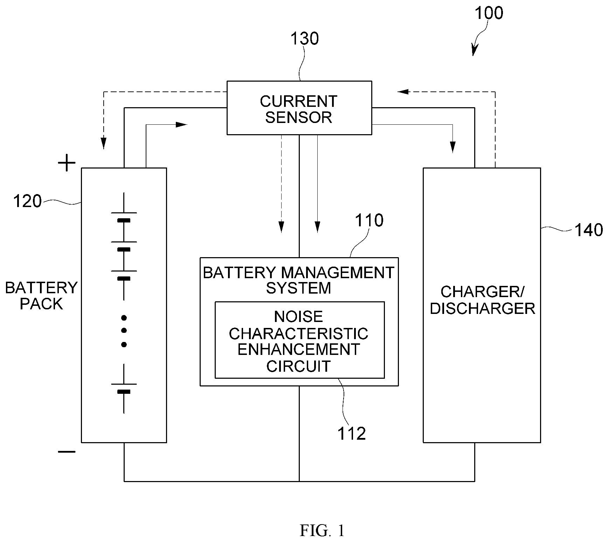

FIG. 1 is a diagram illustrating an example of a vehicle 100 including a charge/discharge noise characteristic enhancement circuit 112 according to an embodiment of the present disclosure. According to an embodiment, the vehicle (and/or vehicle system) 100 may refer to an electric vehicle or an autonomous vehicle that obtains power by rotating a motor with electricity accumulated in a battery. For example, the vehicle 100 may include components such as a battery management system (BMS) 110 for monitoring and controlling the state of a battery such as a cell, a module, or a pack, a battery pack 120, a charger/discharger 140 for managing charging/discharging of the battery pack 120, and a current sensor 130 for detecting current during general operation and charging/discharging.

According to an embodiment, the battery management system 110 may include a plurality of MCUs for monitoring, managing, and/or controlling the state of the battery. Here, the MCU may refer to a unit in which a processor, a memory, and a programmable input/output module are integrated, and the battery management system 110 may monitor, manage, and/or control the state of the battery using the plurality of MCUs. When an abnormal signal related to the battery is detected, the battery management system 110 may reset a related MCU to cut off power to the entire system.

According to an embodiment, the battery management system 110 may include the charge/discharge noise characteristic enhancement circuit 112 to prevent an abnormal signal from being incorrectly detected due to noise generated during charging/discharging of the battery pack 120. For example, the charge/discharge noise characteristic enhancement circuit 112 may determine whether the battery pack 120 is in a charge/discharge state based on a current value detected by the current sensor 130. In addition, the charge/discharge noise characteristic enhancement circuit 112 may perform an operation to prevent an MCU from being reset due to noise by distinguishing between an abnormal signal and noise generated during charging/discharging.

Although FIG. 1 illustrates that the vehicle 100 includes the battery management system 110, the battery pack 120, the current sensor 130, and the charger/discharger 140, this is for describing the operation of the charge/discharge noise characteristic enhancement circuit 112, and the vehicle 100 may further include various sensors, devices, and/or systems. With such a configuration, the vehicle 100 and/or the vehicle system can precisely distinguish between noise and actual an abnormal signal generated during charging/discharging of the battery pack 120 and perform MCU reset control.

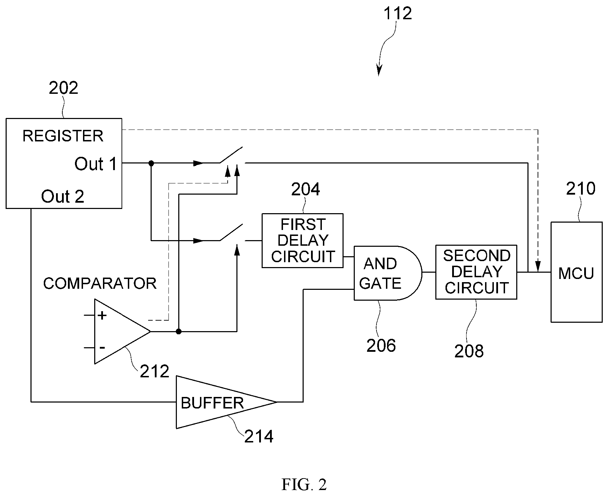

FIG. 2 is a diagram illustrating the operation of the charge/discharge noise characteristic enhancement circuit 112 during a normal operation according to an embodiment of the present disclosure. As illustrated, the charge/discharge noise characteristic enhancement circuit 112 may include a register 202 for detecting an abnormal signal, a first delay circuit 204, an AND gate 206, a second delay circuit 208, an MCU 210, a comparator 212, a buffer 214, etc. In FIG. 2, a dotted line represents current flow.

According to an embodiment, when the battery management system detects an abnormal signal, the MCU 210 may be reset by a HIGH signal output from the register 202. In this case, the battery management system may perform an operation for distinguishing between the occurrence of the actual abnormal signal and an error caused by noise generated during charging/discharging based on the noise characteristic enhancement circuit 112.

According to an embodiment, when an abnormal signal is detected due to charge/discharge noise or an actual abnormal phenomenon, a first MCU reset signal may be output from an output port "Out 1" of the register 202, and a register signal may be output from an output port "Out 2". In this case, the comparator 212 may perform ON/OFF control of a first switch that directly connects the register 202 and the MCU 210 or a second switch that connects the register 202 and the first delay circuit 204 to establish a path between the register 202 and the MCU 210.

According to an embodiment, the comparator 212 may be used to determine whether the battery performs the normal operation or charging/discharging operation. For example, a current value received from the current sensor may be input to the (+) input port of the comparator 212, and a set threshold value may be input to the (-) input port. Here, the threshold value may be set to a value slightly greater than a current that generally flows in the battery. That is, when the current value received from the current sensor is lower than the threshold value, the comparator 212 may output a first comparison signal (low voltage signal) to control the first switch to be turned on and control the second switch to be turned off.

When the first switch is controlled to be turned on by the comparator 212, the first MCU reset signal output from the register 202 may be directly provided to the MCU 210. In this case, the MCU 210 may perform a reset operation based on the first MCU reset signal.

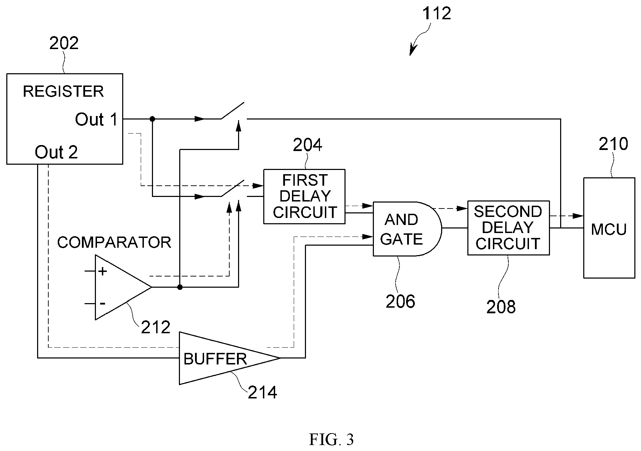

FIG. 3 is a diagram illustrating the operation of the charge/discharge noise characteristic enhancement circuit 112 during a charge/discharge operation of the battery according to an embodiment of the present disclosure. As illustrated, the charge/discharge noise characteristic enhancement circuit 112 may include the register 202 for detecting an abnormal signal, the first delay circuit 204, the AND gate 206, the second delay circuit 208, the MCU 210, the comparator 212, the buffer 214, etc. In FIG. 3, dotted lines represent current flow.

According to an embodiment, when an abnormal signal is detected due to charge/discharge noise or an actual abnormal phenomenon, the first MCU reset signal may be output from the output port "Out 1" of the register 202, and the register signal may be output from the output port "Out 2". As described above in FIG. 2, a current value received from the current sensor may be input to the (+) input port of the comparator 212, and a set threshold value may be input to the (-) input port. For example, when the current value received from a current sensor is higher than the threshold value, the comparator 212 may output a second comparison signal (high voltage signal) to control the second switch to be turned ON and control the first switch to be turned off.

When the second switch is controlled to be turned on by the comparator 212, the first MCU reset signal output from the register 202 may be input to the first delay circuit 204. In this case, the first delay circuit 204 may delay the first MCU reset signal to output a second MCU reset signal. For example, the first delay circuit 204 may detect whether the first MCU reset signal is maintained as a HIGH signal during a first delay time and output the second MCU reset signal based thereon. That is, when a HIGH signal is temporarily output due to charge/discharge noise, the first MCU reset signal will be converted to a LOW signal, and thus it can be primarily determined whether the abnormal signal is due to charge/discharge noise during the first delay time.

If the first MCU reset signal is maintained as a HIGH signal during the first delay time, the second MCU reset signal may be provided to the AND gate 206. In this case, the register signal output from the output port "Out 2" of the register 202 may also be provided to the AND gate 206 via the buffer 214. According to an embodiment, the AND gate 206 may output a third MCU reset signal as a HIGH signal when both the second MCU reset signal and the register signal are HIGH signals.

The third MCU reset signal output by the AND gate 206 may be provided to the second delay circuit 208. In this case, the second delay circuit 208 may delay the third MCU reset signal and output a fourth MCU reset signal. For example, the second delay circuit 208 may detect whether the third MCU reset signal is maintained as a HIGH signal during a second delay time, and output the fourth MCU reset signal based thereon. That is, when a HIGH signal is temporarily output due to charge/discharge noise, the third MCU reset signal will be converted to a LOW signal, and thus it can be secondarily determined whether the abnormal signal is due to charge/discharge noise during the second delay time. In this case, the MCU 210 may perform a reset operation based on the fourth MCU reset signal.

In addition, when the third MCU reset signal is provided to the second delay circuit 208, an algorithm for determining charge/discharge noise may be executed. For example, the battery management system may determine whether a reset register signal output from a reset register is a HIGH signal. When the reset register signal is a HIGH signal, the battery management system may determine whether a register signal of an abnormal signal detection register is a HIGH signal. If the register signal is a HIGH signal, the battery management system may determine whether a power cutoff command has been output. If it is determined that a power cutoff command has been output, it can be determined that an actual abnormal signal, not a charge/discharge noise, has been generated.

With such a configuration, the battery management system can enhance characteristics of noise generated during charging/discharging of the battery and/or battery pack based on the charge/discharge noise characteristic enhancement circuit and can effectively prevent the MCU 210 from being incorrectly reset due to charge/discharge noise based thereon.

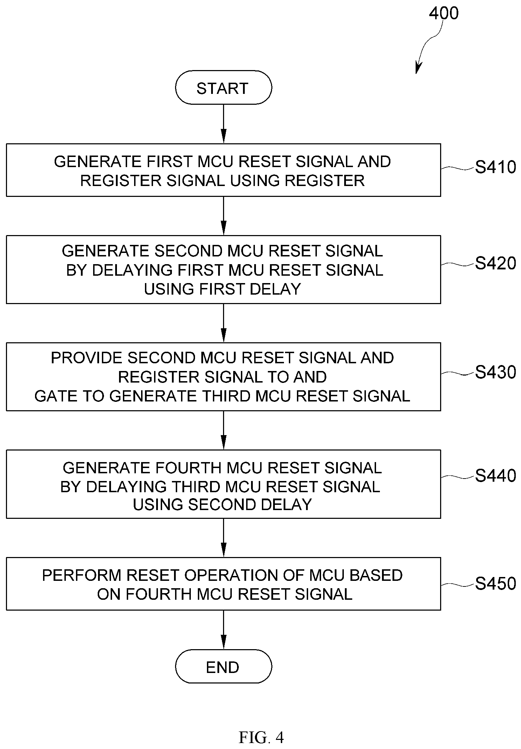

FIG. 4 is a flowchart illustrating an example of a charge/discharge noise characteristic enhancement method 400 according to an embodiment of the present disclosure. The charge/discharge noise characteristic enhancement method 400 may be performed by at least one processor (e.g., at least one processor of a vehicle system and/or a battery management system). The charge/discharge noise characteristic enhancement method 400 may be initiated by the processor using a register to generate a first MCU reset signal and a register signal (S410). In general, when an abnormal signal is detected, the first MCU reset signal and the register signal may have a value of 1, i.e., they may be HIGH signals.

According to an embodiment, the generated first MCU reset signal may be transmitted to a first delay circuit. For example, during charging/discharging of the battery, an associated switch (e.g., the second switch) may be controlled to be turned on by a comparator, and accordingly, the generated first MCU reset signal may be transmitted to the first delay circuit. In this case, the processor may generate a second MCU reset signal by delaying the first MCU reset signal using the first delay circuit (S420). For example, the processor may continuously detect change in the first MCU reset signal output from the register during a first delay time of the first delay circuit, and may generate a second MCU reset signal if the HIGH signal is maintained.

According to an embodiment, the processor may generate a third MCU reset signal by providing the second MCU reset signal and the register signal to an AND gate (S430). For example, the register signal may be provided to the AND gate through a buffer, and the processor may generate the third MCU reset signal by using the AND gate if both the second MCU reset signal and the register signal are HIGH signals. At this time, the generated third MCU reset signal may be provided to a second delay circuit.

According to an embodiment, the processor may generate a fourth MCU reset signal by delaying the third MCU reset signal using the second delay circuit (S440). For example, the processor may continuously detect change in the third MCU reset signal output from the AND gate during a second delay time of the second delay circuit, and if the HIGH signal is maintained, the processor may generate a fourth MCU reset signal. In this case, the processor may also determine whether an abnormal operation of an MCU is detected in addition to whether the third MCU reset signal is maintained as a HIGH signal to generate the fourth MCU reset signal. If the fourth MCU reset signal is generated in this manner, the processor may perform a reset operation of the MCU based on the fourth MCU reset signal (S450).

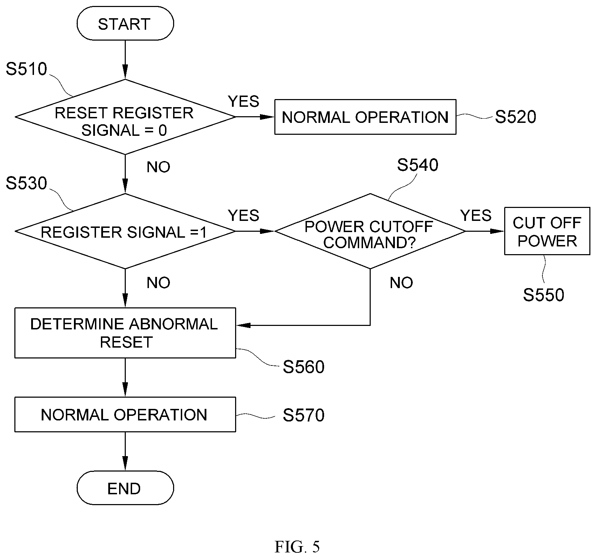

FIG. 5 is a flowchart illustrating an example of a method 500 of detecting an abnormal operation of an MCU according to an embodiment of the present disclosure. The method 500 of detecting an abnormal operation of an MCU may be performed by at least one processor (e.g., at least one processor of a vehicle system and/or a battery management system). The method 500 of detecting an abnormal operation of an MCU may be initiated by the processor determining whether a reset register signal is "0" (a LOW signal) (S510). Here, the reset register may be a separate register from an abnormal signal detection register.

According to an embodiment, upon determining that the reset register signal is "0", the processor determines that an abnormal signal related to the battery is not detected and may perform a normal operation of the MCU (S520). On the other hand, upon determining that the reset register signal is "1" (a HIGH signal), the processor may determine whether a signal of the abnormal signal detection register is "1" (S530).

In a typical abnormal signal occurrence situation, the reset register signal and the abnormal signal detection register signal will both be "1", and thus if the register signal is determined to be "0", the processor may determine abnormal reset (S560). In this case, the processor may perform the normal operation of the MCU (S570).

If the register signal is determined to be "1", the processor may determine whether a power cutoff command has been output (S540). In a typical abnormal signal occurrence situation, the power cutoff command is output when the reset register signal and the abnormal signal detection register signal are both be "1", and thus the processor may determine abnormal reset if the power cutoff command is not output (S560). In this case, the processor may perform the normal operation of the MCU (S570).

On the other hand, upon determining that power cutoff command has been output, the processor may clear the register and cut off the power of the MCU (S550). In an abnormal signal occurrence situation, the values of the reset register signal and the register signal are both converted to "1", and the power of the MCU can be cut off by the power cutoff command. That is, the processor may determine that an abnormal signal has occurred only when all three conditions are satisfied. In addition, if any one of the three conditions is not satisfied, the processor may determine that an incorrect signal has been detected due to charge/discharge noise and perform or command the normal operation of the MCU.

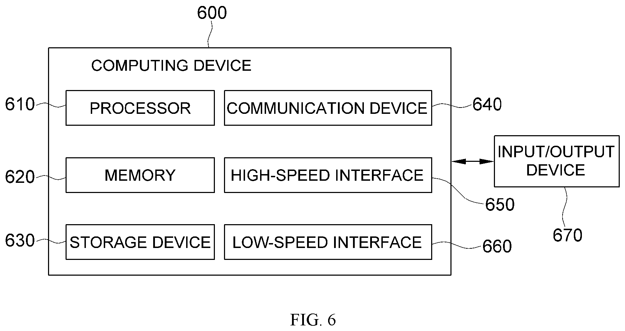

FIG. 6 illustrates a computing device 600 for performing the above-described methods and/or embodiments. According to an embodiment, the computing device 600 may include the vehicle system and/or battery management system described above. For example, the computing device 600 may refer to any module, device, and/or system for information processing.

The computing device 600 includes a processor 610, a memory 620, a storage device 630, a communication device 640, a high-speed interface 650 connected to the memory 620 and a high-speed expansion port, and a low-speed interface 660 connected to a low-speed bus and the storage device. The components 610, 620, 630, 640, and 650 may be interconnected using various buses and may be mounted on the same main board or may be mounted and connected in another suitable manner. The processor 610 may be configured to process instructions of a computer program by performing basic arithmetic, logic, and input/output operations. For example, the processor 610 may process instructions stored in the memory 620, the storage device 630, etc., and/or instructions executed within the computing device 600 and display graphical information on an external input/output device 670, such as a display device, coupled to the high-speed interface 650.

The communication device 640 may provide a configuration or function for the input/output device 670 and the computing device 600 to communicate with each other through a network, and may provide a configuration or function for supporting the input/output device 670 and/or the computing device 600 to communicate with other external devices, etc. For example, a request or data generated by a processor of an external device according to any program code may be transmitted to the computing device 600 through a network under the control of the communication device 640. Conversely, a control signal or command provided under the control of the processor 610 of the computing device 600 may be transmitted to another external device through the communication device 640 and the network.

Although the computing device 600 is illustrated as including one processor 610, one memory 620, etc. in FIG. 6, the present disclosure is not limited thereto, and the computing device 600 may be implemented using multiple memories, multiple processors, and/or multiple buses. Further, although FIG. 6 illustrates one computing device 600, the present disclosure is not limited thereto, and multiple computing devices may interact and perform operations necessary to execute the method described above.

The memory 620 may store information within the computing device 600. According to an embodiment, the memory 620 may be configured as a volatile memory unit or multiple memory units. Additionally or alternatively, the memory 620 may be configured as a non-volatile memory unit or multiple memory units. In addition, the memory 620 may be configured as another form of computer-readable media, such as a magnetic disc or an optical disc. In addition, the memory 620 may store an operating system and at least one program code and/or instruction.

The storage device 630 may be one or more mass storage devices for storing data for the computing device 600. For example, the storage device 630 may be a computer-readable medium including, or configured to include, a magnetic disc such as a hard disk, a removable disk, an optical disc, a semiconductor memory device such as an erasable programmable read-only memory (EPROM), an electrically erasable PROM (EEPROM), a flash memory device, a CD-ROM, and a DVD-ROM disk. In addition, a computer program may be tangibly implemented in such a computer-readable medium.

The high-speed interface 650 and the low-speed interface 660 may be means for interacting with the input/output device 670. For example, the input device may include devices such as a camera including an audio sensor and an image sensor, a keyboard, a microphone, and a mouse, and the output device may include devices such as a display, a speaker, and a haptic feedback device. In another example, the high-speed interface 650 and the low-speed interface 660 may be means for interfacing with a device having integrated configurations or functions for performing input and output, such as a touchscreen.

In an embodiment, the high-speed interface 650 may manage bandwidth-intensive operations with respect to the computing device 600, whereas the low-speed interface 660 may manage less bandwidth-intensive operations than the high-speed interface 650. In an embodiment, the high-speed interface 650 may be coupled to the memory 620, the input/output device 670, and high-speed expansion ports that can accommodate various expansion cards. Additionally, the low-speed interface 660 may be coupled to the storage device 630 and low-speed expansion ports. Additionally, the low-speed expansion ports, which may include various communication ports (e.g., USB, Bluetooth, Ethernet, wireless Ethernet), may be coupled to one or more input/output devices 670, such as a keyboard, a pointing device, and a scanner, or a networking device, such as a router, a switch, or the like, via a network adapter.

Although FIG. 6 illustrates that the input/output device 670 is not included in the computing device 600, the present disclosure is not limited thereto and the input/output device 670 may be integrated with the computing device 600. In addition, although FIG. 6 illustrates that the high-speed interface 650 and/or the low-speed interface 660 are separate from the processor 610, the present disclosure is not limited thereto, and the high-speed interface 650 and/or the low-speed interface 660 may be included in the processor.

The above-described method and/or various embodiments may be realized by digital electronic circuitry, computer hardware, firmware, software, and/or a combination thereof. Various embodiments of the present disclosure may be implemented as a computer program executed by a data processing device, for example, one or more programmable processors and/or one or more computing devices, or stored on a computer-readable medium and/or a computer program. The above-described computer program may be written in any form of programming language, including a compiled language or an interpreted language, and may be distributed in any form, such as a standalone program, a module, a subroutine, etc. The computer program may be distributed through a single computing device, multiple computing devices connected through the same network, and/or multiple computing devices distributed to be connected through multiple different networks.

The above-described method and/or various embodiments may be performed by one or more processors configured to execute one or more computer programs that process, store, and/or manage any function, functions, etc. by operating on the basis of input data or generating output data. For example, the method and/or various embodiments of the present disclosure may be performed by special purpose logic circuitry such as a field programmable gate array (FPGA) or an application specific integrated Circuit (ASIC), and the device and/or system for performing the method and/or embodiments of the present disclosure may be implemented as a special purpose logic circuit such as an FPGA or an ASIC.

The one or more processors executing the computer program may include a general purpose or special purpose microprocessor and/or one or more processors of any kind of digital computing device. The processor may receive instructions and/or data from each of a read-only memory and a random access memory, or may receive instructions and/or data from the read-only memory and the random access memory. In the present disclosure, the components of the computing device performing the method and/or embodiments may include one or more processors for executing instructions, one or more memories for storing instructions and/or data.

In an embodiment, the computing device may exchange data with one or more mass storage devices for storing data. For example, the computing device may receive data from and/or transmit data to a magnetic disc or an optical disc. A computer-readable medium suitable for storing instructions and/or data associated with a computer program may include, but is not limited to, any form of nonvolatile memory, including semiconductor memory devices such as an erasable programmable read-only memory (EPROM), an electrically erasable PROM (EEPROM), and a flash memory device. For example, the computer-readable medium may include a magnetic disc, such as an internal hard disk or a removable disk, a photomagnetic disc, a CD-ROM, and a DVD-ROM disk.

In order to provide interaction with a user, the computing device may include, but is not limited to, a display device (e.g., a cathode ray tube (CRT), a liquid crystal display (LCD), or the like) for providing or displaying information to the user, and a pointing device (e.g., a keyboard, a mouse, a trackball, or the like) for allowing the user to provide input and/or commands to the computing device. That is, the computing device may further include any other types of devices for providing interaction with the user. For example, the computing device may provide any form of sensory feedback to the user for interaction with the user, including visual feedback, auditory feedback, and/or tactile feedback. In this regard, the user may provide input to the computing device through various gestures, such as visual, vocal, and motion.

In the present disclosure, various embodiments may be implemented in a computing device including a back-end component (e.g., a data server), a middleware component (e.g., an application server), and/or a front-end component. In this case, the components may be interconnected by any form or medium of digital data communication, such as a communication network. According to an embodiment, the communication network may include a wired network such as Ethernet, a wired home network (power line communication), a telephone line communication device, and RS-serial communication, a mobile communication network, a wireless LAN (WLAN), Wi-Fi, Bluetooth, and ZigBee, or a combination thereof. For example, the communication network may include a local area network (LAN), a wide area network (WAN), etc.

A computing device based on the embodiments described herein may be implemented using hardware and/or software configured to interact with a user, including a user device, a user interface (UI) device, a user terminal, or a client device. For example, the computing device may include a portable computing device such as a laptop computer. Additionally or alternatively, the computing device may include, but is not limited to, a personal digital assistants (PDA), a tablet, a game console, a wearable device, an Internet-of-Things (IoT) device, a virtual reality (VR) device, an augmented reality (AR) device, and the like. The computing device may further include other types of devices configured to interact with a user. Furthermore, the computing device may include a portable communication device (e.g., a mobile phone, a smartphone, a wireless cellular phone, and the like) suitable for wireless communication over a network, such as a mobile communication network. The computing device may be configured to wirelessly communicate with a network server using wireless communication technologies and/or protocols, such as Radio Frequency (RF), Microwave Frequency (MWF), and/or Infrared Ray Frequency (IRF).

The various embodiments including specific structural and functional details in the present disclosure are only some of the embodiments. Therefore, the embodiments of the present disclosure are not limited to those described above, and may be implemented in various other forms. In addition, the terminology used in the present disclosure is intended to describe some embodiments and is not to be construed as limiting the embodiments. For example, the singular words may be construed to include plural forms unless the context clearly indicates otherwise.

In the present disclosure, unless otherwise defined, all terms used in this specification, including technical or scientific terms, have the same meaning as commonly understood by a person skilled in the art to which such concepts belong. In addition, commonly used terms, such as terms defined in dictionaries, should be interpreted as having a meaning consistent with the meaning in the context of the relevant technology.

Although the present disclosure has been described in connection with some embodiments herein, various modifications and changes may be made without departing from the scope of the present disclosure as understood by a person skilled in the art to which the present disclosure belongs. In addition, such modifications and changes should be considered to fall within the scope of the claims appended hereto.

## Claims

1. A charge/discharge noise characteristic enhancement circuit, comprising:
a register configured to detect an abnormal signal and output a first micro control unit (MCU) reset signal and a register signal;
a first delay circuit configured to delay the first MCU reset signal output from the register and output a second MCU reset signal;
an AND gate configured to receive the second MCU reset signal and the register signal and output a third MCU reset signal;
a second delay circuit configured to delay the third MCU reset signal output from the AND gate and output a fourth MCU reset signal; and
a MCU configured to perform a reset operation based on the first MCU reset signal or the fourth MCU reset signal.

2. The charge/discharge noise characteristic enhancement circuit of claim 1, further comprising a comparator configured to determine a normal operation or a charge/discharge operation of a battery based on a current value received from a current sensor.

3. The charge/discharge noise characteristic enhancement circuit of claim 2, wherein the comparator is configured to determine the normal operation or the charge/discharge operation of the battery based on whether the current value received from the current sensor is higher than a threshold value.

4. The charge/discharge noise characteristic enhancement circuit of claim 2, further comprising a first switch connecting the register and the MCU,
wherein the first switch is controlled to be turned on by a first comparison signal output from the comparator based on the current value received from the current sensor being determined to be lower than a threshold value.

5. The charge/discharge noise characteristic enhancement circuit of claim 2, further comprising a second switch connecting the register and the first delay circuit,
wherein the second switch is controlled to be turned on by a second comparison signal output from the comparator based on the current value received from the current sensor being determined to be higher than a threshold value.

6. The charge/discharge noise characteristic enhancement circuit of claim 1, further comprising a buffer configured to receive the register signal and transmit the register signal to the first delay circuit.

7. The charge/discharge noise characteristic enhancement circuit of claim 1, wherein the first delay circuit is configured to output the second MCU reset signal based on the first MCU reset signal being maintained as a HIGH signal during a first delay time.

8. The charge/discharge noise characteristic enhancement circuit of claim 1, wherein the AND gate is configured to output the third MCU reset signal based on both the second MCU reset signal and the register signal being HIGH signals.

9. The charge/discharge noise characteristic enhancement circuit of claim 1, wherein the second delay circuit is configured to output the fourth MCU reset signal based on the third MCU reset signal being maintained as a HIGH signal during a second delay time.

10. A vehicle system comprising:
a battery pack;
a charger/discharger configured to charge and discharge the battery pack;
a current sensor connected between the battery pack and the charger/discharger and configured to provide current flowing in the battery pack to a battery management system (BMS); and
the battery management system including a charge/discharge noise characteristic enhancement circuit configured to detect an abnormal signal and reset a micro control unit (MCU).

11. The vehicle system of claim 10, wherein the charge/discharge noise characteristic enhancement circuit comprises:
a register configured to detect the abnormal signal and output a first MCU reset signal and a register signal;
a first delay circuit configured to delay the first MCU reset signal output from the register and output a second MCU reset signal;
an AND gate configured to receive the second MCU reset signal and the register signal and output a third MCU reset signal; and
a second delay circuit configured to delay the third MCU reset signal output from the AND gate and output a fourth MCU reset signal,
the MCU is configured to perform a reset operation based on the first MCU reset signal or the fourth MCU reset signal.

12. A battery charge/discharge noise enhancement method performed by at least one processor, the method comprising:
generating a first micro control unit (MCU) reset signal and a register signal using a register;
generating a second MCU reset signal by delaying the first MCU reset signal using a first delay circuit;
providing the second MCU reset signal and the register signal to an AND gate to generate a third MCU reset signal;
generating a fourth MCU reset signal by delaying the third MCU reset signal using a second delay circuit; and
performing a reset operation of an MCU based on the fourth MCU reset signal.

13. The battery charge/discharge noise enhancement method of claim 12, further comprising determining a normal operation or a charge/discharge operation of a battery based on a current value received from a current sensor using a comparator.

14. The battery charge/discharge noise enhancement method of claim 12, wherein the generating the second MCU reset signal by delaying the first MCU reset signal using the first delay circuit comprises:
determining whether the first MCU reset signal is maintained as a HIGH signal during a first delay time; and
generating the second MCU reset signal based on the first MCU reset signal being determined to be maintained as the HIGH signal during the first delay time.

15. The battery charge/discharge noise enhancement method of claim 12, wherein the generating the fourth MCU reset signal by delaying the third MCU reset signal using the second delay circuit comprises:
determining whether the third MCU reset signal is maintained as a HIGH signal during a second delay time; and
generating the fourth MCU reset signal based on the third MCU reset signal being determined to be maintained as the HIGH signal during the second delay time.

16. The battery charge/discharge noise enhancement method of claim 15, wherein the generating the fourth MCU reset signal by delaying the third MCU reset signal using the second delay circuit further comprises determining whether an abnormal operation of the MCU is detected during the second delay time, and
wherein the generating the fourth MCU reset signal comprises generating the fourth MCU reset signal based on the third MCU reset signal being maintained as the HIGH signal during the second delay time and the abnormal operation of the MCU being detected based on the third MCU reset signal being determined to be maintained as the HIGH signal during the second delay time.

17. The battery charge/discharge noise enhancement method of claim 16, wherein the determining whether the abnormal operation of the MCU is detected during the second delay time comprises:
determining whether a reset register signal output from a reset register is a HIGH signal;
determining whether the register signal is a HIGH signal based on the reset register signal being the HIGH signal;
determining whether a power cutoff command has been output based on the register signal being the HIGH signal; and
determining that the abnormal operation of the MCU is detected based on the power cutoff command being determined to have been output.
